# EUROPÄISCHE PATENTSCHRIFT

(11) **EP 2 886 245 B1**
(45) Veröffentlichungstag und Bekanntmachung des Hinweises auf die Patenterteilung: **12.06.2019**
(21) Anmeldenummer: 13197694.6
(22) Anmeldetag: 17.12.2013
(51) Int. Cl.: B23K 35/26, B23K 35/36, B23K 35/02, H05K 3/34

(54) **LOTPASTE MIT ADIPINSÄURE, OXALSÄURE UND AMINKOMPONENTE**
SOLDERING PASTE WITH ADIPIC ACID, OXALIC ACID AND AMINE COMPONENTS
PÂTE DE BRASAGE AVEC ACIDE ADIPIQUE, ACIDE OXALIQUE ET COMPOSANTS AMINÉS

(43) Veröffentlichungstag der Anmeldung: 24.06.2015
(73) Patentinhaber: Heraeus Deutschland GmbH & Co. KG, 63450 Hanau (DE)
(72) Erfinder: Nachreiner, Jens, 36381 Schlüchtern (DE); Wiese, Joachim, 64739 Höchst (DE); Fritzsche, Sebastian, 63454 Hanau (DE)
(74) Vertreter: Heraeus IP

(56) Entgegenhaltungen:
- EP-A1- 0 389 218
- WO-A1-2011/023394
- DE-A1-102005 053 553
- GB-A- 2 198 676
- US-A- 5 417 771

## Beschreibung

Die vorliegende Erfindung betrifft eine Lotpaste für das Befestigen von elektronischen Bauteilen auf Substraten, die eine Mischung aus Oxalsäure, Adipinsäure und einer Aminkomponente enthält, sowie ein Verfahren zur Herstellung derselben. Weiterhin betrifft die vorliegende Erfindung ein Verfahren zur Befestigung eines elektronischen Bauteils auf einem Substrat unter Verwendung der erfindungsgemäßen Lotpaste sowie ein Modul, das die erfindungsgemäße Lotpaste umfasst.

Lotpasten, insbesondere Weichlotpasten, finden vor allem in der Fertigung von elektronischen Schaltungen Anwendung und dienen hauptsächlich als elektrische und thermische Verbindung zwischen einem Bauteil und einem Substrat, beispielsweise einem Halbleiterchip und einer Leiterplatte (PCB). Dabei wird die Lotpaste auf die Leiterplatte aufgebracht. Der Halbleiterchip wird dann über die Lotpaste mit der Leiterplatte in Kontakt gebracht. Die Lotpaste wird erwärmt, um das Lot in der Paste durch einen Reflow-Prozess aufzuschmelzen, wodurch elektrische und/oder thermische Kontakte zwischen dem Halbleiterchip und der Leiterplatte gebildet werden. Die Lotpasten enthalten in der Regel Flussmittel, die unter anderem dazu dienen, die Oxidschicht auf den Oberflächen des Lotpulvers, des Bauteils und des Substrates aufzulösen und so für eine bessere Benetzbarkeit beim Lötprozess zu sorgen. Da Lotpasten in der automatischen Fertigung von elektronischen Schaltungen überwiegend im Sieb- und Schablonendruck verarbeitet werden, enthalten die Flussmittel in der Regel zusätzlich Substanzen, wie beispielsweise Tenside und Additive, die die rheologischen Eigenschaften des Flussmittels, und damit der Lotpaste, verbessern.

DE 10 2012 019 198 A1 beschreibt eine Flussmittelzusammensetzung, die eine Carbonsäure und ein Polyaminflussmittel umfasst, wobei das Polyamin unsubstituierte C₅₋₈₀-Alkylgruppen mit mindestens zwei tertiären Kohlenstoffatomen umfasst.

EP 0 619 162 A2 offenbart ein Lotflussmittel, das eine 2-Bisoxazolin-Verbindung, ein Dithiol, eine organische Carbonsäure und einen Aktivator umfasst. Weiterhin kann das Lotflussmittel ein organisches Lösungsmittel, ein thermoplastisches Harz und/oder eine Epoxy-Gruppen enthaltende Verbindung aufweisen.

DE 42 35 575 C2 beschreibt eine Weichlotpaste zum Löten von elektronischen Bauteilen und Schaltungen unter Schutzgas, insbesondere unter Stickstoff mit einem niedrigen Restsauerstoffgehalt. Dabei besteht die Weichlotpaste aus einem organischen Harz, einem Aktivator und einem Lösungsmittel.

DE 41 19 012 C1 betrifft eine mit Wasser abspülbare Lotpaste für Elektronikteile, die als Flussmittelgemisch wasserlösliche Salze von Fettaminen mit organischen Säuren enthält.

WO 2010/000679 A1 betrifft Lotmaterialien, die Metallstearate enthalten. Dabei weisen die Partikel des Lotpulvers eine feine Schicht aus festem Metallstearat auf der Oberfläche auf.

US 2009/0152331 A1 beschreibt eine harzfreie Lotpaste, die ein Metallpulver, ein polares Lösungsmittel, eine Carbonsäure und ein tertiäres Amin aufweist. Die Paste ist besonders für die Unterfüllung (under-bumb-metalization) sowie für das Befestigen von oberflächenmontierten Bauteilen (surface mounted technology) geeignet. US5417771A offenbart Lotflussmittel umfassend eine Bis(2-oxazolin)verbindung, eine Dithiolverbindung und eine organische Carbonsäureverbindung. Als Beispiele für organische Carbonsäuren werden unter anderem Oxalsäure und Adipinsäure genannt. Das Lotflussmittel kann Aminsalze von Halogenwasserstoffsäuren als Aktivatoren enthalten.

Eine besondere Herausforderung bei der Fertigung von elektronischen Schaltungen ist das Aufbringen und Befestigen von Bauteilen, die neben elektrischen Anschlussstellen auch über thermische Anschlussstellen auf der Unterseite des Bauteils verfügen, wie beispielsweise QFPs mit Kontaktierungen zu entsprechenden Wärmesenken im Substrat. Die elektrischen Anschlussstellen, sogenannte "Beinchen", dienen ebenfalls als Abstandshalter zwischen dem Bauteil und dem Substrat und werden im Verlauf des Reflow-Prozesses über entsprechende Lotdepots kontaktiert. Die thermischen Anschlussstellen werden ebenfalls mittels Reflow-Prozess über Lotdepots mit dem Substrat verbunden, wobei die Lotpasten, die für die thermische Kontaktierung verwendet werden, sich von denen unterscheiden können, die für die elektrische Kontaktierung des Bauteils mit dem Substrat eingesetzt werden. Dabei kann es vorkommen, dass das eingebrachte Lotdepot der thermischen Anschlussstellen beim Erwärmen verläuft. Dabei werden Lotpulverpartikel, meist in Form sogenannter Lotkugeln, in Richtung der elektrischen Anschlussstellen ausgetrieben und können dort zu Kurzschlüssen führen. Um dies zu verhindern, besteht Bedarf an Lotpasten, die während des Erwärmens nicht verlaufen und wobei die Entstehung von unerwünschten Lotkugeln an den elektrischen Anschlussstellen, und damit Kurzschlüsse, verhindert werden, während gleichzeitig eine stabile mechanische, thermische und/oder elektronische Verbindung zwischen dem Bauteil und dem Substrat geschaffen wird. Weiterhin besteht Bedarf an Lotpasten, die beim Aufschmelzen klare Benetzungsränder ausbilden und somit das präzise Bedrucken von Substraten, und damit der Fertigen von kleinen integralen Schaltungen, erlauben.

Es ist daher Aufgabe der vorliegenden Erfindung, eine Lotpaste für die Befestigung von Bauteilen, insbesondere Bauteilen mit elektrischen Anschlussstellen, auf Substraten bereitzustellen, die beim Erwärmen während des Lotprozesses klare Benetzungsgrenzen ausbildet und formtreu bleibt. Auf diese Weise werden ein Kontakt zwischen der Lotpaste und den elektrischen Anschlussstellen vermieden und Kurzschlüsse unterbunden. Weiterhin ist es Aufgabe der vorliegenden Erfindung, eine Lotpaste bereitzustellen, die für eine mechanische und thermische Verbindung zwischen Bauteil und Substrat sorgt, ohne dass es beim Erwärmen der Lotpaste zu einem Ausfließen derselben und/oder der Entstehung von unerwünschten Lotkugeln kommt.

Weiterhin war es Aufgabe der Erfindung Lotpasten bereitzustellen, die sowohl eine gute Verarbeitbarkeit der Paste in Siebdruckverfahren als auch gleichzeitig eine gute Benetzbarkeit aufweisen.

Die Aufgabe wird durch die Gegenstände der unabhängigen Ansprüche der vorliegenden Erfindung gelöst.

Es wurde überraschend gefunden, dass der Zusatz von Adipinsäure und Oxalsäure in Verbindung mit einem speziellen Amin dazu führt, dass die Lotpaste beim Erwärmen nicht ausfließt, so dass die Entstehung von Lotkugeln und damit von Kurzschlüssen verhindert werden können. Gleichzeitig wurde überraschend gefunden, dass die Benetzbarkeit und Verarbeitbarkeit erheblich verbessert werden konnte.

Unter dem Begriff "ausfließen" im Rahmen der vorliegenden Erfindung ist ein Zerfließen der Lotpaste an den thermischen Anschlussstellen des Bauteils bei Erwärmen zu verstehen, insbesondere unter den thermischen Bedingungen während des Befestigungsverfahrens, aufgrund dessen es zur Entstehung von Lotkugeln und dadurch zu elektrischen Kurzschlüssen an den elektrischen Anschlussstellen des Bauteils führen kann.

Es hat sich als besonders vorteilhaft erwiesen, wenn das Flussmittel neben Dicarbonsäuren weiterhin eine Aminkomponente aufweist.

Ein Gegenstand der vorliegenden Erfindung ist daher eine Lotpaste umfassend
a) Flussmittel umfassend
   i) 7 bis 13 Gew.-%, bezogen auf das Gesamtgewicht des Flussmit-tels, Adipinsäure;
   ii) 0,3 bis 2,0 Gew.-%, bezogen auf das Gesamtgewicht des Flussmittels, Oxalsäure; und
   iii) 0,1 bis 2,0 Gew.-%, bezogen auf das Gesamtgewicht des Flussmittels, Amin ausgewählt aus der Gruppe bestehend aus Aminkomponente A und Aminkomponente B, wobei Aminkomponente A ausgewählt ist aus der Gruppe bestehend aus 1,2-Tetramethylethylendiamin, 1,2-Tetraethylethylendiamin und 1,2-Tetrapropylethylendiamin und wobei Aminkomponente B ausgewählt ist aus der Gruppe bestehend aus N-Coco-1,3-Diaminopropan, 1,6-Diaminohexan, 1,7-Diaminoheptan, 1,8-Diaminooktan, 1,9-Diaminononan und 1,10-Diaminodecan; und
b) 80 bis 97 Gew.-%, bezogen auf das Gesamtgewicht der Lotpaste, eines Lots auf Zinnbasis, wobei das Flussmittel zusätzlich Dicarbonsäuren, die von Oxalsäure und Adipinsäure verschieden sind, in einer Menge von 0 bis 2 Gew.-%, bezogen auf das Gesamtgewicht des Flussmittels, aufweist, und wobei die Gesamtmenge aller Dicarbonsäuren im Flussmittel maximal 15 Gew.-%, bezogen auf das Gesamtgewicht des Flussmittels, beträgt.

Ein wesentlicher Bestandteil der erfindungsgemäßen Lotpasten ist das Flussmittel.

### a) Flussmittel

Neben den Dicarbonsäuren Adipinsäure und Oxalsäure umfasst das Flussmittel als wesentlichen Bestandteil 0,1 bis 2,0 Gew.-%, bezogen auf das Gesamtgewicht des Flussmittels, Amin ausgewählt aus der Gruppe bestehend aus Aminkomponente A und Aminkomponente B, wobei Aminkomponente A ausgewählt ist aus der Gruppe bestehend aus 1,2-Tetramethylethylendiamin, 1,2-Tetraethylethylendiamin und 1,2-Tetrapropylethylendiamin und wobei Aminkomponente B ausgewählt ist aus der Gruppe bestehend aus N-Coco-1,3-Diaminopropan, 1,6-Diaminohexan, 1,7-Diaminoheptan, 1,8-Diaminooktan, 1,9-Diaminononan und 1,10-Diaminodecan.

### Aminkomponente A

Aminkomponente A ist ausgewählt aus der Gruppe bestehend aus 1,2-Tetramethylethylendiamin, 1,2-Tetraethylethylendiamin und 1,2-Tetrapropylethylendiamin, beispielsweise 1,2-Tetra-n-propylethylendiamin und 1,2-Tetra-iso-propylethylendiamin.

### Aminkomponente B

Durch die Verwendung der erfindungsgemäßen Lotpaste für die Befestigung von Bauteilen mit elektrischen und/oder thermischen Anschlussstellen auf Substraten, beispielsweise Leiterplatten, wird das Auftreten von Kurzschlüssen an den elektrischen Anschlussstellen vermindert, da es zu keinem unerwünschten Kontakt zwischen den Anschlussstellen kommt. Es wurde weiterhin überraschend gefunden, dass sich die Eigenschaften der Lotpaste bezüglich des Ausfließens weiter verbessern lassen, wenn Aminkomponente B eine primäre Aminogruppe aufweist.

Aminkomponente B ist ausgewählt aus der Gruppe bestehend aus N-Coco-1,3-diaminopropan, 1,6-Diaminohexan, 1,7-Diaminoheptan, 1,8-Diaminooktan, 1,9-Diaminononan und 1,10-Diaminodecan.

Vorzugsweise hat der von Kokosöl abgeleitete Rest des N-Coco-1,3-diaminopropan eine Kettenlänge von 8 bis 20 Kohlenstoffatomen. Eine typische Verteilung der Kohlenstoffkettenlängen der von Kokosöl abgeleiteten Alkylreste weist beispielsweise die folgende Zusammensetzung in Mol-% auf: 5% C8, 6% C10, 50% C12, 19% C14, 10% C16 und 10% C18.

Die Menge an Amin im Flussmittel ist vorzugsweise so gewählt, dass eine gute Verarbeitbarkeit der Lotpaste sowie eine gute Benetzung der Oberflächen des zu befestigenden Bauteils und des Substrates gewährleistet sind.

Das Flussmittel weist Aminkomponente A und/oder Aminkomponente B in einer Menge von 0,1 bis 2,0 Gew.-%, vorzugsweise von 0,4 bis 1,0 Gew.-%, jeweils bezogen auf das Gesamtgewicht des Flussmittels, auf.

Es hat sich ebenfalls überraschend gezeigt, dass die erfindungsgemäße Lotpaste gute Ausfließeigenschaften aufweist, wenn alternativ zu Aminkomponente A, Aminkomponente B eingesetzt wird.

In einer bevorzugten Ausführungsform weist das Flussmittel der erfindungsgemäßen Lotpaste zusätzlich Monoamin auf. Das Monoamin liegt zusätzlich zu der Aminkomponente A und/oder der Aminkomponente B vor.

Besonders gute Ergebnisse, vor allem hinsichtlich der Verarbeitbarkeit, des Ausfließverhaltens und der Aufschmelzeigenschaften der erfindungsgemäßen Lotpaste, können erzielt werden, wenn es sich bei dem Monoamin um ein sekundäres und/oder tertiäres Monoamin handelt. Daher ist eine Ausführungsform bevorzugt, in der das Monoamin ausgewählt ist aus der Gruppe bestehend aus sekundärem Monoamin und tertiärem Monoamin sowie Mischungen davon. Vorzugsweise umfasst das Flussmittel Monoamin in einer Menge von 0,5 bis 5,5 Gew.-%, vorzugsweise von 1,0 bis 5,0 Gew.-%, jeweils bezogen auf das Gesamtgewicht des Flussmittels. In einer besonders bevorzugten Ausführungsform umfasst das Monoamin 3 bis 15, vorzugsweise 4 bis 12 Kohlenstoffatome. Weiterhin bevorzugt ist das Monoamin ausgewählt aus der Gruppe bestehend aus Bis(2-ethylhexyl)amin, Bis(2-methylhexylamin), Diethylamin, Triethylamin, Cyclohexylamin, Diethanolamin und Triethanolamin.

Weiterhin hat es sich gezeigt, dass durch die Menge an Dicarbonsäure im Flussmittel die Verarbeitbarkeit, die Benetzungs- und Ausfließeigenschaften der Lotpaste weiter positiv verstärkt werden können.

Das Flussmittel weist Adipinsäure in einer Menge von 7 bis 13 Gew.-%, vorzugsweise von 8 bis 12 Gew.-%, jeweils bezogen auf das Gesamtgewicht des Flussmittels, auf.

Vor allem die Benetzungseigenschaften und das Aufschmelzverhalten der Lotpaste können durch die Wahl der geeigneten Menge an Dicarbonsäure im Flussmittel eingestellt werden.

Das Flussmittel weist Oxalsäure in einer Menge von 0,3 bis 2,0 Gew.-%, vorzugsweise von 0,4 bis 1,5 Gew.-%, besonders bevorzugt von 0,45 bis 1,0 Gew.-%, jeweils bezogen auf das Gesamtgewicht des Flussmittels, auf.

Liegt die Menge an Oxalsäure im Flussmittel unterhalb der angegebenen Grenze von 0,3 Gew.-%, bezogen auf das Gesamtgewicht des Flussmittels, zeigen die entsprechenden Lotpasten geringfügig verbesserte Eigenschaften, was das Ausfließverhalten beim Erwärmen angeht. Weiterhin hat sich gezeigt, dass die Menge an Oxalsäure vorteilhafterweise in dem oben angegebenen Bereich liegt, um ein optimales Aufschmelzen der entsprechenden Lotpaste zu erreichen.

Weiterhin hat sich gezeigt, dass die Zugabe weiterer Dicarbonsäuren, die von Oxalsäure und Adipinsäure verschieden sind, zum Flussmittel einen positiven Einfluss auf die Eigenschaften der Lotpaste hat, insbesondere auf die Verarbeitbarkeit und die Ausfließeigenschaften. Allerdings sollte auch hier die Menge an weiterer Dicarbonsäure begrenzt sein.

Das Flussmittel weist zusätzlich Dicarbonsäuren, die von Oxalsäure und Adipinsäure verschieden sind, in einer Menge von 0 bis 2,0 Gew.-%, vorzugsweise in einer Menge von 0,01 bis 1,0 Gew.-%, jeweils bezogen auf das Gesamtgewicht des Flussmittels, auf. Es hat sich gezeigt, dass eine Menge, die oberhalb des erfindungsgemäßen Bereichs liegt, negative Auswirkungen auf die Benetzungseigenschaften der Lotpaste haben kann.

Vorzugsweise sind die zusätzlichen Dicarbonsäuren, die von Oxalsäure und Adipinsäure verschieden sind, ausgewählt aus der Gruppe bestehend aus Malonsäure, Bernsteinsäure und Glutarsäure.

Die Gesamtmenge aller Dicarbonsäuren im Flussmittel beträgt maximal 15 Gew.-%, vorzugsweise 7 bis 13 Gew.-%, insbesondere 8 bis 12 Gew.-%, jeweils bezogen auf das Gesamtgewicht des Flussmittels.

Um eine optimale Verarbeitbarkeit der erfindungsgemäßen Lotpaste zu gewährleisten, vor allem unter dem Gesichtspunkt der automatischen Verarbeitung, kann die erfindungsgemäße Lotpaste weitere Komponenten enthalten, die dazu dienen, das Aufbringen der Lotpaste, deren Fließverhalten sowie die elektrische und thermische Verbindung von Bauteil und Substrat zu unterstützen.

So kann die erfindungsgemäße Lotpaste beispielsweise Verdickungsmittel enthalten. In einer bevorzugten Ausführungsform umfasst das Flussmittel zusätzlich ein oder mehrere Verdickungsmittel ausgewählt aus der Gruppe bestehend aus Ethylcellulose, hydriertes Rizinusöl, Glycerin-tris-12-hydroxystearin und modifiziertes Glycerin-tris-12-hydroxystearin. Vorzugsweise weist das Flussmittel Verdickungsmittel in einer Menge von 1,0 bis 4,0 Gew.-%, bevorzugt von 1,7 bis 3,0 Gew.-%, jeweils bezogen auf das Gesamtgewicht des Flussmittels, auf.

Um das Auftragen und die Benetzungseigenschaften der erfindungsgemäßen Lotpaste zu verbessern, kann das Flussmittel weiterhin Lösungsmittel enthalten. Vorzugsweise ist das Lösungsmittel ausgewählt aus der Gruppe bestehend aus bei 25 °C flüssiger Diole, Alkohole, Etheralkohole und Ketone, insbesondere Trimethylpropanol, 1,2-Oktandiol, 1,8-Oktandiol, 2,5-Dimethyl-2,5-hexandiol, iso-Bornylcyclohexanon, Glykolether, 2-Ethyl-1,3-hexandiol, n-Decylalkohol, 2-Methyl-2,4-pentandiol, Terpineol und Isopropanol sowie Mischungen davon. In einer weiteren bevorzugten Ausführungsform ist der Glykolether ausgewählt aus der Gruppe bestehend aus Mono-, Di-, Tri-Propylenglykolmethylether, Mono-, Di-, Tri-Propylenglykol-n-butylether, Mono-, Di-, TriEthylenglykol-n-butylether, Ethylenglykolmethylether, Triethylenglykolmethylether, Diethylenglykol-dibutylether, Tetraethylenglykoldimethylether und Diethylenglykolmonohexylether sowie Mischungen davon.

Weiterhin kann das Flussmittel der erfindungsgemäßen Lotpaste ein Harz aufweisen, um der Paste die für die jeweilige Verwendung benötigte Konsistenz zu verleihen. In einer bevorzugten Ausführungsform der Lotpaste zeichnet sich diese dadurch aus, dass das Flussmittel zusätzlich ein Harz aufweist, bevorzugt ein Harz ausgewählt aus der Gruppe bestehend aus Kolophonium, Tallöl, hydriertes Kolophonium, dimerisiertes Kolophonium, teilweise dimerisiertes Kolophonium und Mischungen davon.

In einer bevorzugten Ausführungsform der erfindungsgemäßen Lotpaste umfasst das Flussmittel das Harz in einer Menge von 35 bis 50 Gew-%, vorzugsweise von 40 bis 48 Gew.-%, jeweils bezogen auf das Gesamtgewicht des Flussmittels.

In einer weiter bevorzugten Ausführungsform der Lotpaste umfasst das Flussmittel zusätzlich halogenhaltige Verbindungen ausgewählt aus der Gruppe bestehend aus Anilinhydrochlorid, Glutaminsäurehydrochlorid, Diethanolaminhydrochlorid, Diethanolaminhydrobromid, Triethanolaminhydrochlorid, Triethanolaminhydrobromid und trans-2,3-Dibrom-2-buten-1,4-diol sowie Mischungen davon. Die halogenhaltigen Verbindungen können als zusätzliche Aktivatoren dienen, die die Oberflächen des zu verbindenden Bauteils und des Substrates aktivieren und so für eine bessere Verbindung der Komponenten sorgen.

Als besonders vorteilhaft hat es sich erwiesen, wenn die Menge an halogenhaltigen Verbindungen im Flussmittel 5 Gew.-%, bezogen auf das Gesamtgewicht des Flussmittels, nicht überschreitet. Daher ist eine Ausführungsform der erfindungsgemäßen Lotpaste bevorzugt, in der das Flussmittel halogenhaltige Verbindungen in einer Menge von 0,1 bis 3,0 Gew.-%, vorzugsweise 0,5 bis 2,0 Gew.-%, jeweils bezogen auf das Gesamtgewicht des Flussmittels, umfasst.

Weiterhin ist eine Ausführungsform bevorzugt, in der das Flussmittel zusätzlich Additive in einer Menge von 0,05 bis 3,0 Gew.-%, jeweils bezogen auf das Gesamtgewicht des Flussmittels, umfasst. Bei diesen Additiven handelt es sich vorzugsweise um Verbindungen, die die Benetzungseigenschaften der Lotpaste verbessern, wie zum Beispiel ethoxyliertes Aminharz, Aminharz, Methylester von Harzen, n-Oleylsarcosin, Oleylimidazolin sowie Mischungen davon.

### b) Lot

Ein weiterer wesentlicher Bestandteil der erfindungsgemäßen Lotpaste ist ein Lot auf Zinnbasis.

Die Anforderungen, die an eine Lotpaste gestellt werden, die für das Befestigen von Bauteilen mit elektrischen und thermischen Anschlussstellen auf Substraten gestellt werden, betreffen, neben dem Ausfließverhalten, insbesondere während des thermischen Kontaktierungsverfahrens, die thermische Verbindung des Bauteils mit dem Substrat, die ein Abführen der während des Betriebs des Bauteils entstehenden Wärme und eine effiziente Kühlung desselben gewährleitstet.

Daher weist das Lot vorzugsweise eine gute Wärmeleitfähigkeit in Verbindung mit einer begrenzten elektrischen Leitfähigkeit auf. Diese Eigenschaften finden sich vor allem in Loten, die Zinn als Hauptbestandteil aufweisen. Daher ist das Lot ein Lot auf Zinnbasis. Ein Lot auf Zinnbasis im Rahmen der vorliegenden Erfindung beschreibt ein Lot, das mindestens 80 Gew.-%, vorzugsweise mindestens 83 Gew.-%, insbesondere zwischen 85 und 90 Gew.-%, Zinn aufweist, wobei sich die Gewichtsangaben jeweils auf die Gesamtmenge des Lots beziehen.

In einer bevorzugten Ausführungsform kann das Lot neben Zinn weitere Metalle umfassen, um beispielsweise die Liquidustemperatur des Lots auf einen für die jeweilige Anwendung vorteilhaften Bereich einzustellen.

Daher ist eine Ausführungsform bevorzugt, in der das Lot Silber in einer Menge von 0,1 bis 8 Gew.-%, vorzugsweise 0,2 bis 6 Gew.-%, jeweils bezogen auf das Gesamtgewicht des Lots, umfasst.

In einer weiter bevorzugten Ausführungsform umfasst das Lot Kupfer in einer Menge von 0,1 bis 1,5 Gew.-%, vorzugsweise 0,2 bis 1,0 Gew.-%, jeweils bezogen auf das Gesamtgewicht des Lots.

Weiterhin bevorzugt ist eine Ausführungsform, in der das Lot bleifrei ist.

Die erfindungsgemäße Lotpaste eignet sich vor allem für den Einsatz in Reflow-Verfahren, bei denen das Lot bis zu seiner Liquidustemperatur erwärmt wird und so für eine optimale Verbindung zwischen Bauteil und Substrat sorgt. Aus energietechnischen Gesichtspunkten und unter Berücksichtigung der empfindlichen Bauteile und Substrate, sollte daher die Liquidustemperatur des Lots nicht zu hoch sein.

Daher ist eine Ausführungsform bevorzugt, in der das Lot eine Liquidustemperatur in einem Bereich von 200 bis 250 °C, vorzugsweise in einem Bereich von 200 bis 230 °C, aufweist.

In einer bevorzugten Ausführungsform liegt das Lot in Pulverform vor, vorzugsweise mit einer gewichtmittleren Teilchengröße von 15 bis 50 µm, vorzugsweise von 20 bis 45 µm, bestimmt gemäß IPC-TM-650 2.2.14-2.2.14.2.

Die erfindungsgemäße Lotpaste umfasst das Lot in einer Menge von 80 bis 97 Gew.-%, vorzugsweise 83 bis 95 Gew.-%, insbesondere 85 bis 93 Gew.-%, jeweils bezogen auf das Gesamtgewicht der Lotpaste.

Um eine optimale Verarbeitbarkeit und das gewünschte Ausfließverhalten zu erhalten, weist die erfindungsgemäße Lotpaste vorzugsweise eine Viskosität von 50 bis 200 Pa*s auf, bestimmt bei 23 °C und einer Scherrate von 10⁻¹s, gemessen mit Platte-Kegel Rheometer-Messsystem Physica der Firma Anton-Paar.

Ein weiterer Gegenstand der vorliegenden Erfindung ist ein Verfahren zur Herstellung der erfindungsgemäßen Lotpaste.

Dabei umfasst das Verfahren zur Herstellung der erfindungsgemäßen Lotpaste die Schritte:
- Mischen der Komponenten des Flussmittels, insbesondere der Komponenten i), ii) und iii); und
- Zugabe eines Lotpulvers.

Die Zugabe des Lotpulvers erfolgt vorzugsweise in mehreren Portionen unter Rühren zu einer vorgelegten Mischung der Komponenten des Flussmittels. Weiter bevorzugt sind keine erhöhten Temperaturen notwendig, um eine homogene Paste zu erhalten. Daher erfolgt die Zugabe des Lotpulvers vorzugsweise bei Normaltemperatur, beispielsweise bei 20 °C.

Bei dem Lotpulver handelt es sich um ein erfindungsgemäßes Lotpulver, wie oben beschrieben. Weiter bevorzugt handelt es sich bei dem Lotpulver um eine Mischung aus Zinn, Silber und Kupfer, wobei die Menge an Silber 0,1 bis 8 Gew.-%, vorzugsweise 0,2 bis 6 Gew.-%, und die Menge an Kupfer 0,1 bis 1,5 Gew.-%, vorzugsweise 0,2 bis 1,0 Gew.-%, jeweils bezogen auf das Gesamtgewicht des Lotpulvers, beträgt. Vorzugsweise wird die zu 100 Gew.-% fehlende Menge durch Zinn ergänzt.

Ein weiterer Gegenstand der vorliegenden Erfindung ist ein Verfahren zur Befestigung eines Bauteils auf einem Substrat unter Verwendung der erfindungsgemäßen Lotpaste. Das Verfahren umfasst die folgenden Schritte:
a) Bereitstellen eines Bauteils mit elektrischen Anschlussstellen;
b) Bereitstellen eines Substrates, wobei das Substrat eine Oberfläche aufweist, die mit der erfindungsgemäßen Lotpaste versehen ist;
c) Kontaktieren der Oberfläche des Bauteils mit der Oberfläche des Substrates über die Lotpaste; und
d) Erwärmen der Lotpaste über die Liquidustemperatur des Lots.

Bei dem Bauteil handelt es sich vorzugsweise um ein Oberflächen-montiertes Bauteil, das über elektrische Anschlussstellen an den vier Seiten des Bauteilgehäuses verfügt. Vorzugsweise weist das Bauteil eine rechteckige oder quadratische Gehäuseform auf. Besonders bevorzugt handelt es sich bei dem Bauteil um ein Quad Flat Package (QFP) und/oder Varianten davon. Weiterhin weist das Bauteil vorzugsweise eine metallisierte Oberfläche auf, über die die Kontaktierung mit der erfindungsgemäßen Lotpaste erfolgt. Dabei ist das Metall vorzugsweise ausgewählt aus der Gruppe bestehend aus Kupfer, Silber, Aluminium, Gold, Nickel, Zinn, Palladium sowie Legierungen davon.

Das Substrat ist vorzugsweise ein Substrat mit mindestens einer Metalloberfläche, über die die Kontaktierung mit der erfindungsgemäßen Lotpaste erfolgt. Geeignete Substrate sind beispielsweise Substrate aus Metall, Keramik, Papier oder Epoxyharz, die eine metallisierte Oberfläche aufweisen. Die Oberfläche weist vorzugsweise ein Metall ausgewählt aus der Gruppe bestehend aus Kupfer, Silber, Gold, Nickel, Aluminium, Zinn, Palladium sowie Legierungen davon auf.

Die Lotpaste wird über die Liquidustemperatur des Lots erwärmt, so dass es zu einer Verbindung zwischen Bauteil und Substrat über die Lotpaste kommt. Dabei wird die Lotpaste vorzugsweise so erwärmt, dass das Lot in seine Liquidusphase übergeht, jedoch ohne dass es zu einer Beschädigung der Lotpaste, des Bauteils und/oder des Substrates kommt. Das Lot wird vorzugsweise auf eine Temperatur erwärmt, die 5 bis 60 °C, vorzugsweise 10 bis 50 °C, über der Liquidustemperatur des Lots liegt.

Die gemäß dem erfindungsgemäßen Befestigungsverfahren mit dem Substrat befestigten Bauteile weisen ein wesentlich verringertes Auftreten von Kurzschlüssen auf.

Ein weiterer Gegenstand der vorliegenden Erfindung ist daher ein Bauteil, welches auf einem Substrat befestigt ist und welches gemäß dem erfindungsgemäßen Befestigungsverfahren erhältlich ist oder erhalten wird.

Ein weiterer Gegenstand der vorliegenden Erfindung ist die Verwendung der erfindungsgemäßen Lotpaste zum Verbinden von elektronischen Bauteilen mit Substraten, wobei die Kontaktierung der Oberfläche des Substrates und der Oberfläche des Bauteils über die erfindungsgemäße Lotpaste erfolgt.

Ein weiterer Gegenstand der vorliegenden Erfindung ist ein Modul, das unter Verwendung der erfindungsgemäßen Lotpaste erhalten wird. Das Modul umfasst
1) ein Bauteil mit elektrischen Anschlussstellen mit einer ersten Oberfläche,
2) ein Substrat mit wenigstens einer zweiten Oberfläche und
3) eine erfindungsgemäße Lotpaste, die mit der ersten Oberfläche und der zweiten Oberfläche in direktem Kontakt steht.

Das Modul ist vorzugsweise für den Einsatz in integrierten Schaltungen, vor allem in der Halbleiterindustrie, geeignet.

### Beispiele:

Die vorliegende Erfindung soll anhand der folgenden Beispiele näher beschriebene werden, wobei diese nicht als Einschränkung des Erfindungsgedanken zu verstehen sind.

### Testmethoden:

### i) Verarbeitbarkeit:

Die Verarbeitbarkeit der Lotpasten wurde mit Hilfe eines automatischen Schablonendruckers mit Rakel getestet. Dazu wurde die Paste auf eine geschlossene Schablone aufgetragen, wobei die Testdauer 16 Stunden betrug und das Rakel alle 10 Minuten einen Druckvorgang ausführte. Nach Ende des Tests wurde die optische Qualität der Paste beurteilt. Den Pasten wurde eine gute Verarbeitbarkeit bescheinigt, wenn sie sich auch nach wiederholten Überstreichen / Drucken des Rakels über 16 Stunden glatt über die Schablone rollen ließen, ohne dass sich die Paste vor dem Rakel oder an dessen Seiten ansammelte.

### ii) Benetzbarkeit:

Die Benetzungseigenschaften der Pasten wurden mit Hilfe des Aufschmelztests gemäß der IPC-TM-650 Testmethode 2.4.45 beurteilt. Dazu wurde die Paste auf ein Metallsubstrat aufgetragen. Als Substrate dienten Bleche mit einer Abmessung von 20 x 20 x 0,5 mm aus Kupfer oder Messing. Sofern diese Bleche eine Oxidschicht auf der Oberfläche aufwiesen, wurden diese mit Schleifpapier der Körnung P600 metallisch blank geschliffen und mit Alkohol gereinigt. Kupferbleche, die eine helle und reine Oberfläche aufwiesen, wurden lediglich mit Alkohol gereinigt.

Die vorbereiteten Metallsubstrate wurden mit Hilfe einer Schablone bedruckt. Dazu wurde die Schablone fest auf das Substrat gedrückt, so dass sich die offenen Löcher der Schablone in der Mitte des Substrates befanden. Die Paste wurde auf einen Japanspatel gegeben und zuerst leicht, dann mit etwas mehr Druck über die Löcher der Schablone gestrichen, bis sich keine Paste mehr auf der Schablone befand. Dann wurde die Schablone vorsichtig unter Erhalt des durch die Schablone vorgegebenen Musters entfernt.

Das bedruckte Substrat wurde auf eine erste Heizplatte gelegt, die auf eine Temperatur eingestellt war, die unterhalb der Liquidustemperatur des Lotes liegt, im vorliegenden Fall auf 200 °C. Das Substrat wurde für 2 Minuten auf dieser Platte belassen und dann sofort auf eine zweite Heizplatte gelegt, die eine Temperatur aufwies, die ca. 50 °C über der Liquidustemperatur des Lots (Peaktemperatur) lag. Nach Aufschmelzen der Paste wurde das Substrat noch 5 Sekunden auf der Heizplatte belassen und dann von der Platte genommen und abgekühlt.

Nach dem Abkühlen der Paste wurde beurteilt, ob diese zu Flecken aufgeschmolzen war, die der Größe der Löcher der Schablone entsprachen oder zu mehreren kleinen Flecken, und ob die Paste nach dem Aufschmelzen klare Ränder aufwies. Weiterhin wurde beurteilt, ob die Oberfläche glänzend oder matt war.

Die Pasten wurden in 4 Klassen eingeteilt, wobei die Klassen 1 und 2 als befriedigende Ergebnisse eingestuft wurden, während die Klassen 3 und 4 ungenügende Ergebnisse repräsentieren.
Klasse 1: Die Lotpaste ist größer aufgeschmolzen als die zuvor bedruckte Fläche auf dem Substrat. Die Benetzungsränder sind gleichmäßig.
Klasse 2: Die Lotpaste ist genauso groß aufgeschmolzen wie die durch die Schablone vorgegebene bedruckte Fläche. Die Benetzungsränder sind gleichmäßig.
Klasse 3: Die Lotpaste ist zu mehreren großen Flecken aufgeschmolzen. Die Benetzungsränder sind ungleichmäßig und weisen Fehlstellen auf.
Klasse 4: Die Lotpaste ist zu mehreren kleinen Flecken aufgeschmolzen, die kleiner sind als die ursprüngliche bedruckte Fläche, oder die Lotpaste ist gar nicht aufgeschmolzen. Benetzungsränder sind nicht vorhanden.

### iii) Ausfließverhalten

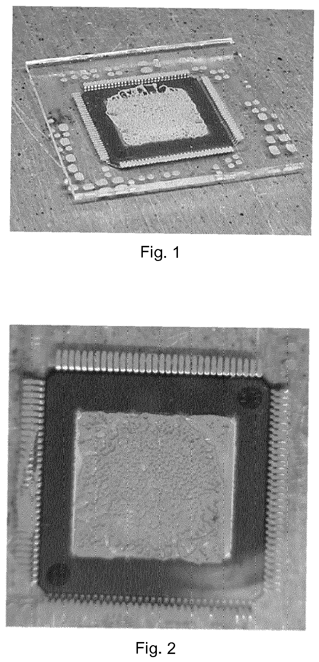

Das Ausfließverhalten der Lotpasten wurde mit Hilfe des Anti-Capillary-Tests (AC-Test) beurteilt. Dazu wurde die Lotpaste auf die thermische Anschlussstelle eines QFP-Bauteils (beispielsweise von Infineon Technologies AG, Deutschland) aufgebracht und mit einer Glasplatte abgedeckt. Das QFP-Bauteil wurde mit der gegenüber liegenden Oberfläche auf eine Heizplatte mit einer Temperatur von 200 °C gelegt, so dass das Verhalten der Paste beurteilt werden konnte. Der Versuchsaufbau ist in Figur 1 dargestellt.

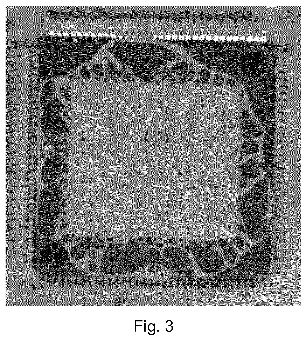

Die erhaltenen Ergebnisse wurden mittels Noten bewertet, wobei 0 bis 2 befriedigende Ergebnisse darstellen, bei denen die Paste nicht über den Bereich der thermischen Anschlussstelle hinaus getreten ist (Figur 2). Noten 2,5 bis 3,0 stehen für ungenügende Ergebnisse, bei denen es aufgrund eines zu starken Zerfließens der Paste zu einem Kontakt zwischen der Lotpaste und den elektrischen Anschlussstellen des Bauteils kann (Figur 3).

Die folgenden Lotpasten wurden anhand der oben aufgeführten Testmethoden beurteilt, wobei sie in mindestens zwei der Tests befriedigende Ergebnisse erzielen müssen, um als erfindungsgemäß zu gelten.

Tabelle 1 zeigt die Zusammensetzung erfindungsgemäßer Lotpasten sowie Pasten, die als Vergleichsbeispiele herangezogen wurden. Die Angaben beziehen sich jeweils auf Gew.-%. Die Eigenschaften der Pasten, wie die Verarbeitbarkeit, die Benetzungs- und die Ausfließeigenschaften, wurden nach den oben beschriebenen Verfahren bestimmt und sind in Tabelle 2 zusammengefasst.

Es wurde folgendes Lot eingesetzt:
SnAgCu: Sn: 96,5% Ag: 3,0% Cu: 0,5%, Typ 3 gemäß IPC J-STD-006 Norm.

**Tabelle 1**

| Beispiel | Vgl. 1 | Vgl.2 | Vgl.3 | 4 | 5 | 6 | 7 | 8 | 9 | Vgl. 10 |
|---|---|---|---|---|---|---|---|---|---|---|
| **Flussmittel** | | | | | | | | | | |
| Adipinsäure | 10,0 | 10,0 | 10,0 | 10,0 | 10,0 | 10,0 | 9,5 | 9,5 | 9,5 | 6,0 |
| Oxalsäure | | | 0,7 | 0,5 | 0,7 | 1,0 | 0,5 | 0,5 | 0,5 | 0,5 |
| Dicarbonsäure | 0,5^{a} | 0,5^{b} | | | | | | | | |
| N-Coco-1,3-diaminopropan | | | | 0,5 | 0,5 | 0,5 | 0,5 | 0,5 | 0,5 | 0,5 |
| Bis-C₈-dialkylamin | 2,1 | 2,1 | 2,1 | | | | | | | |
| N,N-Dialkylfettamin | 2,1 | 2,1 | 2,1 | 3,7 | 3,7 | 3,7 | 3,7 | 3,7 | 3,7 | 3,7 |
| Hydriertes Kolophonium | 45,4 | 45,4 | 45,3 | 45,4 | 45,3 | 45,2 | 45,8 | 44,5 | 46,0 | 47,0 |
| Triethanolamin· HBr | 1,5 | 1,5 | 1,5 | 1,5 | 1,5 | 1,5 | 1,5 | 1,5 | | 1,5 |
| Rizinusöl | 2,7 | 2,7 | 2,7 | 2,7 | 2,7 | 2,7 | 2,7 | 2,7 | 2,7 | 2,7 |
| Tri-Propylenglykol-n-butylether | 35,7 | 35,7 | 35,6 | 35,7 | 35,6 | 35,4 | 35,8 | 37,1 | 37,1 | 38,1 |
| Flussmittel (gesamt) | 100,0 | 100,0 | 100,0 | 100,0 | 100,0 | 100,0 | 100,0 | 100,0 | 100,0 | 100,0 |

| **Paste** | | | | | | | | | | |
|---|---|---|---|---|---|---|---|---|---|---|
| Lot (SnAgCu) | 89,25 | 89,25 | 89,25 | 89,25 | 89,25 | 89,25 | 89,25 | 89,25 | 89,25 | 89,25 |
| Flussmittel | ad 100,0 | ad 100,0 | ad 100,0 | ad 100,0 | ad 100,0 | ad 100,0 | ad 100,0 | ad 100,0 | ad 100,0 | ad 100,0 |

| | | | | | | | | | | |
|---|---|---|---|---|---|---|---|---|---|---|
| a) Bernsteinsäure b) Glutarsäure | | | | | | | | | | |

**Tabelle 2:**

| Beispiel | Vgl. 1 | Vgl.2 | Vgl.3 | 4 | 5 | 6 | 7 | 8 | 9 | Vgl.10 |
|---|---|---|---|---|---|---|---|---|---|---|
| Benetzbarkeit (Klasse) | 3 | 3 | 2 | 2 | 2 | 2 | 2 | 2 | 2 | 4 |
| AC-Test (Note) | 2,5 | 3 | 1 | 1,5 | 1 | 1 | 1 | 1 | 1 | 1 |
| Verarbeitbarkeit | schlecht | schlecht | gut | gut | gut | gut | gut | gut | gut | gut |

Wie Tabelle 2 zu entnehmen ist, zeigen die erfindungsgemäßen Pasten der Beispiele 4 bis 9 sehr gute Ergebnisse im AC-Test sowie in der Benetzbarkeit. Weiterhin ließen sich alle erfindungsgemäßen Pasten gut verarbeiten und waren auch nach wiederholtem Rakelübergang streichfähig. Bei der optischen Prüfung zeigten alle Paste nach dem Aufschmelzen und anschließendem Abkühlen eine glatte und glänzende Oberfläche mit klaren Benetzungsrändern.

Vergleichsbeispiel 1 zeigt eine herkömmliche Lotpaste, die als Säurekomponente neben Adipinsäure 0,5 Gew.-% Bernsteinsäure, bezogen auf das Gesamtgewicht des Flussmittels, aufweist. Wie den Ergebnissen der Tabelle 2 zu entnehmen ist, wies die herkömmliche Paste lediglich ungenügende Ergebnisse bezüglich der getesteten Eigenschaften auf.

Auch der Ersatz von Bernsteinsäure durch die gleiche Menge Glutarsäure, wie in Vergleichsbeispiel 2 dargestellt, brachte keine Verbesserung hinsichtlich der gewünschten Eigenschaften.

Beispiel 10 zeigt, dass durch die Menge an Adipinsäure die Eigenschaften der Lotpaste entsprechend den jeweiligen Anforderungen eingestellt werden kann. So können die Eigenschaften durch eine Menge an Adipinsäure, die im erfindungsgemäßen Bereich liegt, weiter positiv verstärkt werden.

Tabelle 3 zeigt die allgemeine Zusammensetzung verschiedener Pasten, bei denen die Testaminkomponente variiert wurde. Die eingesetzten Testamine sowie die Testergebnisse der Lotpasten sind in Tabelle 4 zusammengefasst.

**Tabelle 3:**

| Komponente | Menge (Gew.-%) |
|---|---|
| Adipinsäure | 10,0 |
| Oxalsäure | 0,5 |
| Testamin | 0,5 |
| Bis-C₈-dialkylamin | 2,1 |
| N,N-Dialkylfettamin | 2,1 |
| Hydriertes Kolophonium | 44,9 |
| Rizinusöl | 2,7 |
| Triethanolamin·HBr | 1,5 |
| Tri-Propylenglykol-n-butylether | 35,7 |
| Flussmittel (gesamt) | 100,0 |

| **Paste** | |
|---|---|
| Lot | 89,25 |
| Flussmittel | add 100,0 |

**Tabelle 4**

| | Testamin | Benetzbarkeit | AC-Test | Verarbeitbarkeit |
|---|---|---|---|---|
| 11 | N-Coco-1,3-diaminopropan | 2 | 0 | gut |
| 12 | 1,6-Diaminohexan | 2 | 0 | gut |
| 13 | 1,10-Diaminodecan | 2 | 0 | gut |
| 14 | 1,2-Tetramethylendiamin | 2 | 1 | gut |
| Vgl.15 | 1,2-Diaminoethan | 2 | 0 | schlecht |
| Vgl.16 | 1,3-Diaminopropan | 2 | 0 | schlecht |
| Vgl.17 | 1,2-Diaminocyclohexan | 3 | 0 | schlecht |

Wie den Beispielen 11 bis 14 der Tabelle 4 zu entnehmen ist, bei denen die eingesetzten Amine unter die erfindungsgemäße Definition der Aminkomponente A (Beispiel 14) oder der Aminkomponente B (Beispiel 11 bis 13) fallen, zeigen die entsprechenden Lotpasten hervorragende Ergebnisse bezüglich der Benetzbarkeit, der Verarbeitbarkeit und des AC-Tests. Sobald die Aminkomponente nicht mehr unter die erfindungsgemäße Definition fallen (Beispiele 15 bis 17) weisen die entsprechenden Lotpasten eine mangelhafte Verarbeitbarkeit auf. In einigen Fällen, wie bei dem Einsatz von Aminen, bei denen die 2 Aminogruppen nicht durch mindestens 3 Kohlenstoffatome voneinander getrennt sind (Vergleichsbeispiel 17) leiden zusätzlich die Benetzungseigenschaften, so dass ein präzises Bedrucken eines Substrates mit diesen Pasten nicht möglich ist.

Wie den aufgeführten Beispielen zu entnehmen ist, weisen alle erfindungsgemäßen Pasten eine gute Verarbeitbarkeit und hervorragende Eigenschaften bezüglich der Benetzbarkeit und des Ausfließverhaltens auf. So ist dank der in der vorliegenden Erfindung beschriebenen Pasten eine stabile Befestigung von Bauteilen auf Substraten möglich, ohne dass es zu Kurzschlüssen kommt, während gleichzeitig eine gute Wärmeabfuhr gewährleistet ist. Aufgrund der guten Verarbeitbarkeit der erfindungsgemäßen Lotpasten ist ein präzises und schnelles Bedrucken von beispielsweise Leiterplatten möglich.

**Tabelle 4**

| | Testamin | Benetzbarkeit | AC-Test | Verarbeitbarkeit |
|---|---|---|---|---|
| 11 | N-Coco-1,3-diaminopropan | 2 | 0 | gut |
| 12 | 1,6-Diaminohexan | 2 | 0 | gut |
| 13 | 1,10-Diaminodecan | 2 | 0 | gut |
| 14 | 1,2-Tetramethylendiamin | 2 | 1 | gut |
| Vgl.15 | 1,2-Diaminoethan | 2 | 0 | schlecht |
| Vgl.16 | 1,3-Diaminopropan | 2 | 0 | schlecht |
| Vgl.17 | 1,2-Diaminocyclohexan | 3 | 0 | schlecht |

Wie den Beispielen 11 bis 14 der Tabelle 4 zu entnehmen ist, bei denen die eingesetzten Amine unter die erfindungsgemäße Definition der Aminkomponente A (Beispiel 14) oder der Aminkomponente B (Beispiel 11 bis 13) fallen, zeigen die entsprechenden Lotpasten hervorragende Ergebnisse bezüglich der Benetzbarkeit, der Verarbeitbarkeit und des AC-Tests. Sobald die Aminkomponente nicht mehr unter die erfindungsgemäße Definition fallen (Beispiele 15 bis 17) weisen die entsprechenden Lotpasten eine mangelhafte Verarbeitbarkeit auf. In einigen Fällen, wie bei dem Einsatz von Aminen, bei denen die 2 Aminogruppen nicht durch mindestens 3 Kohlenstoffatome voneinander getrennt sind (Vergleichsbeispiel 17) leiden zusätzlich die Benetzungseigenschaften, so dass ein präzises Bedrucken eines Substrates mit diesen Pasten nicht möglich ist.

Wie den aufgeführten Beispielen zu entnehmen ist, weisen alle erfindungsgemäßen Pasten eine gute Verarbeitbarkeit und hervorragende Eigenschaften bezüglich der Benetzbarkeit und des Ausfließverhaltens auf. So ist dank der in der vorliegenden Erfindung beschriebenen Pasten eine stabile Befestigung von Bauteilen auf Substraten möglich, ohne dass es zu Kurzschlüssen kommt, während gleichzeitig eine gute Wärmeabfuhr gewährleistet ist. Aufgrund der guten Verarbeitbarkeit der erfindungsgemäßen Lotpasten ist ein präzises und schnelles Bedrucken von beispielsweise Leiterplatten möglich.

## Patentansprüche

1. Lotpaste umfassend
a) Flussmittel umfassend
i) 7 bis 13 Gew.-%, bezogen auf das Gesamtgewicht des Flussmittels, Adipinsäure;
ii) 0,3 bis 2,0 Gew.-%, bezogen auf das Gesamtgewicht des Flussmittels, Oxalsäure; und
iii) 0,1 bis 2,0 Gew.-%, bezogen auf das Gesamtgewicht des Flussmittels, Amin ausgewählt aus der Gruppe bestehend aus Aminkomponente A und Aminkomponente B, wobei Aminkomponente A ausgewählt ist aus der Gruppe bestehend aus 1,2-Tetramethylethylendiamin, 1,2-Tetraethylethylendiamin und 1,2-Tetrapropylethylendiamin und wobei Aminkomponente B ausgewählt ist aus der Gruppe bestehend aus N-Coco-1,3-Diaminopropan, 1,6-Diaminohexan, 1,7-Diaminoheptan, 1,8-Diaminooktan, 1,9-Diaminononan und 1,10-Diaminodecan; und
b) 80 bis 97 Gew.-%, bezogen auf das Gesamtgewicht der Lotpaste, eines Lots auf Zinnbasis, wobei das Flussmittel zusätzlich Dicarbonsäuren, die von Oxalsäure und Adipinsäure verschieden sind, in einer Menge von 0 bis 2 Gew.-%, bezogen auf das Gesamtgewicht des Flussmittels, aufweist, und wobei die Gesamtmenge aller Dicarbonsäuren im Flussmittel maximal 15 Gew.-%, bezogen auf das Gesamtgewicht des Flussmittels, beträgt.

2. Lotpaste gemäß Anspruch 1, **dadurch gekennzeichnet, dass** das Flussmittel zusätzlich 0,5 bis 5,5 Gew.-%, bezogen auf das Gesamtgewicht des Flussmittels, Monoamin ausgewählt aus der Gruppe bestehend aus sekundärem Monoamin und tertiärem Monoamin aufweist.

3. Verfahren zum Herstellen einer Lotpaste gemäß Anspruch 1 oder 2 umfassend die Schritte:
- Mischen der Komponenten des Flussmittels; und
- Zugabe eines Lotpulvers.

4. Verfahren zur Befestigung eines Bauteils auf einem Substrat umfassend die folgenden Schritte:
a) Bereitstellen eines Bauteils mit elektrischen Anschlussstellen;
b) Bereitstellen eines Substrates, wobei das Substrat eine Oberfläche aufweist, die mit einer Lotpaste gemäß Anspruch 1 oder 2 versehen ist,
c) Kontaktieren der Oberfläche des Bauteils mit der Oberfläche des Substrates über die Lotpaste; und
d) Erwärmen der Lotpaste über die Liquidustemperatur des Lots.

5. Modul umfassend
1) ein Bauteil mit elektrischen Anschlussstellen mit einer ersten Oberfläche,
2) ein Substrat mit wenigstens einer zweiten Oberfläche und
3) eine Lotpaste gemäß Anspruch 1 oder 2, die mit der ersten Oberfläche und der zweiten Oberfläche in direktem Kontakt steht.

## Claims

1. Soldering paste, comprising
a) flux, comprising
i) 7 to 13 wt.%, relative to the total weight of the flux, adipic acid;
ii) 0.3 to 2.0 wt.%, relative to the total weight of the flux, oxalic acid; and
iii) 0.1 to 2.0 wt.%, relative to the total weight of the flux, amine selected from the group consisting of amine component A and amine component B, whereby amine component A is selected from the group consisting of 1,2-tetramethyl ethylene diamine, 1,2-tetraethyl ethylene diamine, and 1,2-tetrapropyl ethylene diamine, and whereby amine component B is selected from the group consisting of N-coco-1,3-diaminopropane, 1,6-diaminohexane, 1,7-diaminoheptane, 1,8-diaminooctane, 1,9-diaminononane, and 1,10-diaminodecane; and
b) 80 to 97 wt.%, relative to the total weight of the soldering paste, of a tin-based solder, whereby the flux comprises, in addition, dicarboxylic acids different from oxalic acid and adipic acid in an amount of 0 to 2 wt.%, relative to the total weight of the flux, and whereby the total amount of all dicarboxylic acids in the flux is maximally 15 wt.%, relative to the total weight of the flux.

2. Soldering paste according to claim 1, **characterised in that** the flow comprises, in addition, 0.5 to 5.5 wt.%, relative to the total weight of the flux, monoamine selected from the group consisting of secondary monoamine and tertiary monoamine.

3. Method for the production of a soldering paste according to claim 1 or 2, comprising the steps of:
- mixing the components of the flux; and
- adding a solder powder.

4. Method for attaching a component on a substrate, comprising the following steps of:
a) providing a component with electrical connecting points;
b) providing a substrate, whereby the substrate comprises a surface that is provided with a soldering paste according to claim 1 or 2,
c) contacting the surface of the component to the surface of the substrate by means of the soldering paste; and
d) heating the soldering paste beyond the liquidus temperature of the solder.

5. Module, comprising
1) a component with electrical connecting points with a first surface;
2) a substrate with at least one second surface; and
3) a soldering paste according to claim 1 or 2 that is in direct contact with the first surface and the second surface.

## Revendications

1. Pâte de brasage comprenant
a) un flux comprenant
i) 7 à 13 % en poids, par rapport au poids total du flux, d'acide adipique ;
ii) 0,3 à 2,0 % en poids, par rapport au poids total du flux, d'acide oxalique ; et
iii) 0,1 à 2,0 % en poids, par rapport au poids total du flux, d'amine sélectionnée parmi le groupe constitué du composant d'amine A et composant d'amine B, dans laquelle le composant d'amine A est sélectionné parmi le groupe constitué de la 1,2-tétraméthyléthylènediamine, 1,2-tétraéthyléthylènediamine et 1,2-tétrapropyléthylènediamine, et dans laquelle le composant d'amine B est sélectionné parmi le groupe constitué du N-coco-1,3-diaminopropane, 1,6-diaminohexane, 1,7-diaminoheptane, 1,8-diaminooctane, 1,9-diaminononane et 1,10-diaminodécane ; et
b) 80 à 97 % en poids, par rapport au poids total de la pâte de brasage, d'un métal d'apport de brasage à base d'étain, dans laquelle le flux présente en outre des acides dicarboxyliques qui sont différents de l'acide oxalique et l'acide adipique en une quantité de 0 à 2 % en poids, par rapport au poids total du flux, et dans laquelle la quantité totale de tous les acides dicarboxyliques dans le flux se monte à 15 % en poids maximum, par rapport au poids total du flux.

2. Pâte de brasage selon la revendication 1, **caractérisée en ce que** le flux présente en outre 0,5 à 5,5 % en poids, par rapport au poids total du flux, de monoamine sélectionnée parmi le groupe constitué de monoamine secondaire et de monoamine tertiaire.

3. Procédé de fabrication d'une pâte de brasage selon la revendication 1 ou 2, comprenant les étapes de :
- mélange des composants du flux ; et
- addition d'une poudre de brasage.

4. Procédé de fixation d'un composant sur un substrat comprenant les étapes suivantes de :
a) mise à disposition d'un composant avec des points de raccordement électriques ;
b) mise à disposition d'un substrat, dans lequel le substrat présente une surface qui est pourvue d'une pâte de brasage selon la revendication 1 ou 2,
c) mise en contact de la surface du composant avec la surface du substrat par le biais de la pâte de brasage ; et
d) chauffage de la pâte de brasage au-dessus de la température de liquidus du métal d'apport de brasage.

5. Module comprenant
1) un composant avec des points de raccordement électriques avec une première surface,
2) un substrat avec au moins une seconde surface, et
3) une pâte de brasage selon la revendication 1 ou 2 qui est en contact direct avec la première surface et la seconde surface.
